# EUROPEAN PATENT APPLICATION

(11) **EP 2 908 346 A1**
(43) Date of publication of application: **19.08.2015**
(21) Application number: 15153075.5
(22) Date of filing: 29.01.2015
(51) Int. Cl.: H01L 29/735, H01L 29/78, H01L 27/082, H01L 27/092, H01L 29/06, H01L 29/10

(54) **Pair of transistors with reduced parasitic thyristor**

(30) Priority: 14.02.2014 US 201414180418
(71) Applicant: NXP B.V., 5656 AG Eindhoven (NL)
(72) Inventor: Ritter, Hans-Martin, Redhill, RH1 1SH (GB)
(74) Representative: Crawford, Andrew

(57) **Abstract**

Parasitic thyristor action may be mitigated in semiconductor devices by placement of minority carrier traps (25, 27), illustratively in the base(s) (21) of bipolar transistors or the well (403, 405) of a CMOS transistor pair (Fig. 6). The minority carrier traps include adjacent n and p regions (25, 27 / 419, 421) which may be connected by a conductor (31, 423, 427).

## Description

### FIELD

This disclosure relates to semiconductor devices and methods for their manufacture or fabrication. In particular, this disclosure relates to semiconductor devices having minority carrier traps which help reduce current gain of bipolar transistors that form inherent parasitic thyristors.

### BACKGROUND

In CMOS devices, latch-up is a common problem. Latch-up is caused by inherent parasitic thyristors that can switch to a low ohmic state when triggered accordingly and then cause unwanted current paths between external pins of the circuit.

In semiconductor devices with an ESD structure in the so- called rail-to-rail architecture, unwanted current paths may also be formed by the unwanted triggering of inherent thyristors. Furthermore, functional bipolar transistors in a device may also exhibit parasitic thyristors. Since a thyristor is essentially two coupled transistors, some have addressed this issue by decoupling the two transistors by isolating specific areas of the semiconductor by trenches and/or buried isolation layers (for example, silicon-on-insulator, SOI, structures). Others have attempted to reduce the emitter efficiency of one or both of these transistors by adding highly doped areas that reject the minority carriers with built-in potentials (for example, by use of highly doped buried layers beneath diffusion wells). Another approach has been to reduce the current gain of at least one of the transistors by introducing additional recombination centers (for example, by use of gold doping or radiation defects or implanted dislocation networks).

### SUMMARY

Illustratively, the present disclosure includes a transistor having a minority carrier trap. Further, by way of illustration, , the present disclosure includes a bipolar transistor with emitter, collector, and base having a minority carrier trap located within the base. Further example embodiments include a minority carrier trap having an n doped region and a p doped region adjacent to or very close to the n region. In an embodiment, the closely-spaced n doped region and p doped region may be approximately or precisely 10 microns apart. Further example embodiments include a conductor connecting the n doped and p doped region. The conductor may be either floating or connected to ground or another voltage such as the same voltage as the base. In other example embodiments, the minority carrier trap may surround the emitter on at least three sides. In further embodiments, the minority carrier trap may surround the collector on at least three sides. In yet another embodiment, the minority carrier trap includes n-doped and p-doped regions arranged in a checkerboard pattern. Another possible arrangement includes interdigitated fingers of alternating n and p doped regions. Other geometric patterns which feature alternating n doped and p doped regions are also intended. In another embodiment, the transistor may be a MOS transistor and the minority carrier trap is located in a doped well. Also encompassed are transistors with minority carrier traps which may include one or more p doped regions and respective closely spaced n doped regions. Further encompassed are transistors with minority carrier traps which may include one or more p doped regions and respective adjacent n doped regions. Various combinations and permutations of features are also contemplated.

### BRIEF DESCRIPTION OF THE DRAWINGS

Fig.1 is cross sectional view of an integrated circuit with two bipolar transistors showing an illustrative application;
Fig. 2 is a cross sectional view of a portion of the integrated circuit of Fig 1, showing an illustrative embodiment of the invention;
Fig. 3. is a plan view of an integrated circuit showing another illustrative embodiment of the invention;
Fig. 4 is a plan view of an integrated circuit showing another illustrative embodiment of the invention;
Fig. 5 is a plan view of an integrated circuit showing another illustrative embodiment of the invention;
Fig. 6 is a cross sectional view of a portion of an integrated circuit showing another illustrative embodiment of the invention.
Figs.7A and 7B are cross sectional views of portions of an integrated circuit showing various configurations of illustrative embodiments of the invention.
Fig. 8 is a flow chart which includes steps which may be performed in the fabrication of an illustrative embodiment of the invention.

### DETAILED DESCRIPTION OF EXEMPLARY EMBODIMENTS

The parasitic thyristor in a semiconductor device consists of two coupled bipolar transistors. By reducing the current gain of one or both of these transistors (which comprise the parasitic thyristor), the action of the thyristor can be suppressed. The current gain can be reduced by reducing the base transport factor. The base transport factor is defined as the fraction of minority carriers injected into the base of a bipolar junction transistor that successfully diffuse across the quasineutral width of the base and enter the collector.

Thus, by adding minority traps in the base region of one or both of the transistors that comprise the thyristor, the density of minority carriers will be locally reduced and less minority carriers will reach the collector of the bipolar transistor.

In various illustrative embodiments, minority traps (alternatively termed "minority carrier traps") include one or more p-doped and adjacent n-doped areas that may be shorted electrically with a conductor. Alternatively, a minority trap may include one or more p-doped and closely spaced n-doped regions that may be shorted electrically with a conductor. An illustrative spacing between closely a closely spaced n doped region and p doped region is approximately 10 microns. The n and p regions of the minority trap should be surrounded by a single region which may be either n or p doped itself.

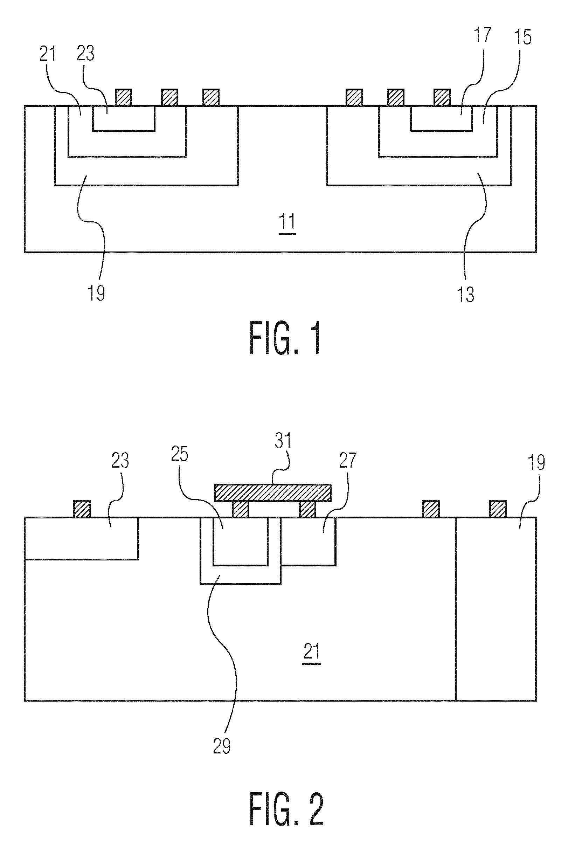

In Fig. 1, there is illustrated two functional bipolar transistors in substrate 11. Illustratively, the substrate 11 is p-doped. One npn transistor is comprised of emitter 23, base 21, and collector 19. Emitter 23 and collector 19 are n-doped, while base 21 is p-doped. Furthermore, another npn transistor is comprised of emitter 17, base 15, and collector 13. Emitter 17 and collector 13 are n-doped, while base 15 is p-doped. A parasitic pnpn thyristor is formed, for example, between base 21, collector 19, substrate 11, and collector 13.

The minority traps comprise one or more p-doped and adjacent n-doped regions that may be shorted electrically with metal on top. The metal may be floating or connected to ground or another voltage. Location of the minority trap(s) in one or both base regions serves to reduce the current gain and reduce the effect of the parasitic thyristor. Fig. 2 provides more detail.

In Fig. 2, there is shown a portion of one of the transistors of Fig. 1. Specifically, there is depicted emitter 23, base 21, and a portion of collector 19. A minority trap comprising n-doped region 25 which is adjacent p-doped region 27 is located within base 21 between emitter region 23 and collector region 19. In Fig. 2, n-doped region 25 and p-doped region 27 are shorted together via conductive contact 31, which may, illustratively, be metal. The minority trap may or may not be connected to an external voltage source. Preferably, the minority trap is connected to the same voltage as base 21. Electrons that are emitted from emitter 23 diffuse through base 21 as minority carriers. The electrons diffuse to the edge of the space charge region 29 of n-doped region 25 since the minority carrier density is very low there. The electrons will be transported by the electrical field in the space charge region. The additional charge added to n-doped region 25 will flow to p-doped region 27 via the interconnect 31 and will be thence drained to the base by yanking a majority carrier. Thus a minority carrier (electron) is transformed into a majority carrier (hole) and will not reach the collector 19. Thus, the current gain of the npn transistor is reduced.

In all of the illustrative embodiments, the doping polarities can be interchanged and similar minority traps may be formed for pnp transistors by substituting p for n and vice versa.

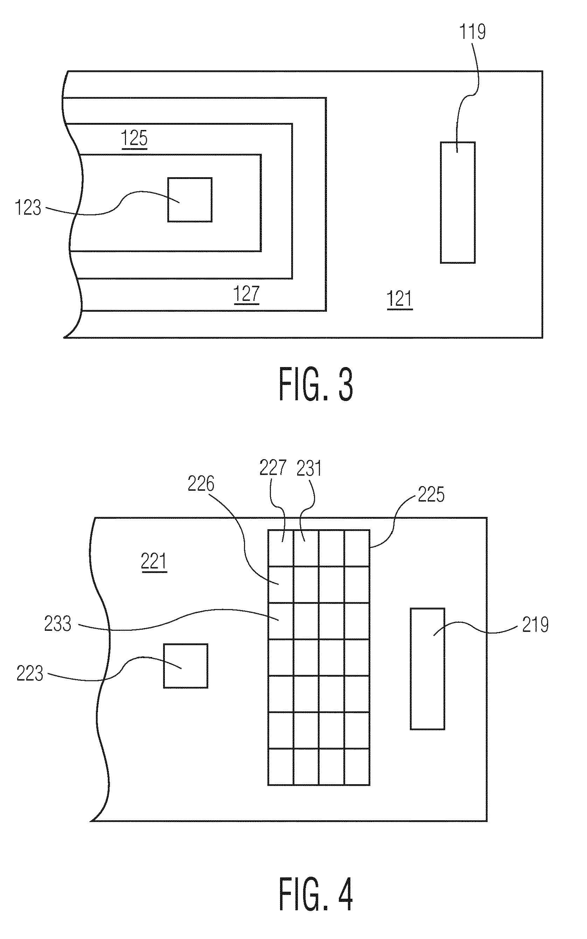

Another illustrative embodiment is depicted in Fig. 3. In Fig. 3, reference numeral 123 illustratively denotes an n doped emitter; reference numeral 121 denotes a p-doped base and reference numeral 119 denotes an n-doped collector. The minority trap is comprised of n-doped region 125 adjacent p-doped region 127. The minority trap located in base 121 encircles the emitter or at least occludes the emitter on three sides, thereby inhibiting minority carrier transfer to collector 119.

The minority trap may alternatively be formed around the collector. Such an embodiment may also be understood by reference to Fig. 3 if reference numeral 123 is interpreted to denote the collector; reference numeral 121 still denotes a base; and reference numeral 119 denotes an emitter. Thus, the minority trap, denoted by reference numerals 125 and 127 may be seen to surround or occlude collector 123.

A further illustrative embodiment may be seen in Fig. 4. Reference numeral 223 denotes an emitter; reference numeral 221 denotes a base; and reference numeral 219 denotes a collector. Minority trap 225 is a checkerboard arrangement of n-doped and p-doped regions adjacent to each other. For example, reference numerals 227 and 233 may be n-doped and reference numerals 226 and 231 may be p-doped. One may choose to connect adjacent n and p-doped regions with conductive connectors.

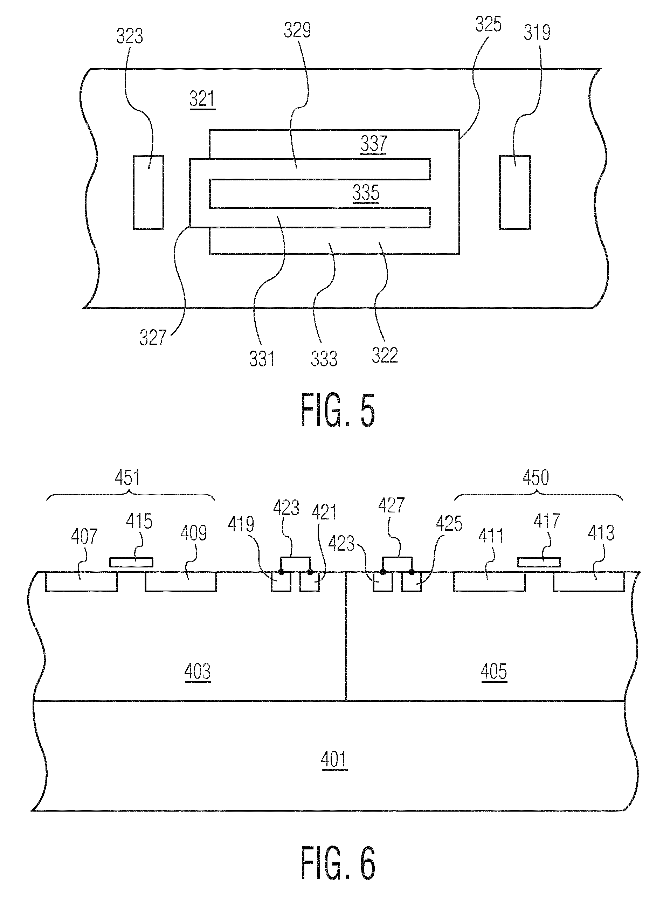

A further illustrative embodiment may be seen in Fig. 5. Reference numeral 323 denotes an emitter; reference numeral 321 denotes a base; and reference numeral 319 denotes a collector. Minority trap 325 is an interdigitated finger arrangement of n doped and p doped regions. For example, reference numeral 327 may denote an n doped region and reference numeral 322 may denote a p doped region. N doped region 327 has fingers 329 and 331 and p doped region has fingers 333, 335, and 337. The oppositely doped regions of the interdigitated fingers may be in contact with each other or may, as mentioned before, be closely spaced.

The present invention may be used, for example, not only in functional bipolar transistors, but also in bipolar protection devices with an ESD protection structure in so-called rail to rail architectures.

The present invention may also be used in CMOS devices. For example, Fig. 6 denotes a CMOS pair of MOS transistors, 450 and 451. Illustratively, reference numeral 401 denotes a p substrate. Reference numeral 403 denotes an n well; reference numeral 405 denotes a p well. Reference numerals 407 and 409 denote p doped source and drain respectively in n well 403. Reference numerals 411 and 413 denote n doped drain and source respectively in p well 405. Reference numerals 415 and 417 denote gates. A parasitic thyristor can be formed as follows: the pnp transistor of the thyristor is formed by p doped drain 409; n well 403; and p well 405; and the npn transistor is formed by n source 411; p well 405; and n well 403. Minority catchers may be formed in both the n well 403 and the p well 405. For example, a minority catcher in the n well 403 may be formed by a p region 419 and a closely spaced apart n region 421. P region 419 and n region 421 are connected by a conductor, shown schematically and denoted by reference numeral 423 Furthermore, a minority catcher may be formed in p well 405 by p doped region 423 and n doped region 425 which are closely spaced apart. P region 423 and n region 425 are connected by a conductor, shown schematically and denoted by reference numeral 427. In n well 403, the positions of p doped regions and n doped region 421 may be interchanged. Similarly, in p well 405, the positions of p doped region 423 and n doped region 425 may be interchanged. Since both n well 403 and p well 405 serve as bases for the bipolar transistors that constitute the parasitic thyristor, it is advantageous to locate minority catchers in both the n well 403 and p well 405.

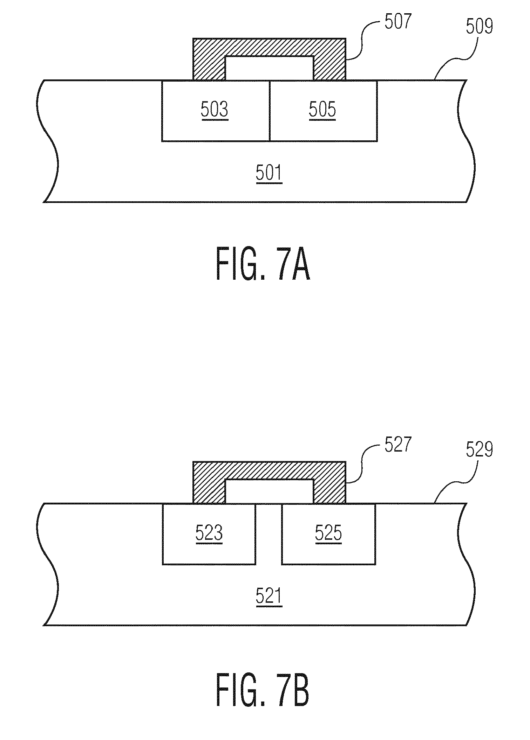

Figs. 7A through 7B illustrate some illustrative configurations for minority catchers. For example, in Fig. 7A, there is depicted a body of semiconductor material 501 which may, illustratively, be a base region of a bipolar transistor or a well region of one transistor of a CMOS pair. Reference numerals 503 and 505 denote p and n doped regions respectively. Reference numeral 507 denotes a conductive material which connects p and n doped regions 503 and 505. Reference numeral 509 denotes an upper surface of semiconductor material 501. A second illustrative embodiment of a minority catcher is depicted in Fig. 7B in which reference numeral 521 denotes a body of semiconductor material which may, illustratively, be a base region of a bipolar transistor or a well region of one transistor of a CMOS pair. Reference numerals 523 and 525 denote p and n doped regions respectively. Reference numeral 529 denotes an upper surface of semiconductor material 521. Reference numeral 527 denotes a conductive material that connects p doped region 523 and n doped region 525. It will be noted that in Fig. 7B, that the p region 523 and n region 525 are slightly separated, whereas in Fig 7A the respective p and n doped regions are in contact with each other within their respective semiconductor materials 501 and 511.

Formation of minority traps may be accomplished, illustratively, by methods known to those of skill in the art, typically implantation, and thermal activation or diffusion of the implant to form a doped area. For example, the processes used to form the base and/ or emitter in a typical bipolar fabrication process may, with appropriate masking, also be used to form the n and p doped regions of a minority catcher. Then, if desired, the n and p doped regions of the minority catcher may be connected with conductive material as part of the process steps which are used to form interconnections.

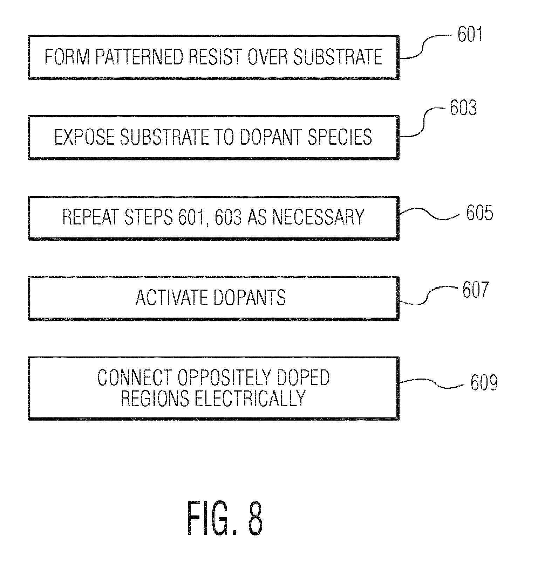

Fig. 8 is a flow chart containing steps which may be followed in the formation of various illustrative embodiments. After selection of a suitable substrate, which may be illustratively, a base region in a partially formed bipolar transistor or a well of a partially formed MOS transistor of a CMOS pair, one may form a patterned resist over such substrate, as indicated by reference numeral 601 of Fig. 8. The substrate may then be exposed to a dopant species, either n, or p, via implantation or diffusion or the like as provided by reference numeral 603. As indicated by reference numeral 605, the substrate may be exposed to the opposite dopant species by repetition of steps 601 and 603. The n and p dopants may then be activated as indicated by step 607. In those cases where it is desirable, a connector may be formed and positioned to connect the n and p doped regions as indicated by step 609.

Various exemplary embodiments are described in reference to specific illustrative examples. The illustrative examples are selected to assist a person of ordinary skill in the art to form a clear understanding of, and to practice the various embodiments. However, the scope of systems, structures and devices that may be constructed to have one or more of the embodiments, and the scope of methods that may be implemented according to one or more of the embodiments, are in no way confined to the specific illustrative examples that have been presented. On the contrary, as will be readily recognized by persons of ordinary skill in the relevant arts based on this description, many other configurations, arrangements, and methods according to the various embodiments may be implemented.

To the extent positional designations such as top, bottom, upper, lower have been used in describing this disclosure, it will be appreciated that those designations are given with reference to the corresponding drawings, and that if the orientation of the device changes during manufacturing or operation, other positional relationships may apply instead. As described above, those positional relationships are described for clarity, not limitation.

The present disclosure has been described with respect to particular embodiments and with reference to certain drawings, but the invention is not limited thereto, but rather, is set forth only by the claims. The drawings described are only schematic and are non-limiting. In the drawings, for illustrative purposes, the size of various elements may be exaggerated and not drawn to a particular scale. It is intended that this disclosure encompasses inconsequential variations in the relevant tolerances and properties of components and modes of operation thereof. Imperfect practice of the invention is intended to be covered.

Where the term "comprising" is used in the present description and claims, it does not exclude other elements or steps. Where an indefinite or definite article is used when referring to a singular noun, e.g. "a" "an" or "the", this includes a plural of that noun unless something otherwise is specifically stated. Hence, the term "comprising" should not be interpreted as being restricted to the items listed thereafter; it does not exclude other elements or steps, and so the scope of the expression "a device comprising items A and B" should not be limited to devices consisting only of components A and B. This expression signifies that, with respect to the present disclosure, the only relevant components of the device are A and B.

## Claims

1. A transistor , comprising a minority carrier trap.

2. The transistor of claim 1 in which said minority carrier trap is comprised of an n-doped region and a p doped region adjacent said n-doped region.

3. The transistor of claim 2 in which said n and p doped region are connected by a conductor.

4. The transistor of claim 3 having emitter, collector and base, comprising a minority carrier trap located within said base.

5. The transistor of claim 3 in which said conductor is floating.

6. The transistor of claim 4 in which said conductor is connected to the same voltage as the base.

7. The transistor of claim 4 in which said minority carrier trap surrounds the emitter on at least three sides.

8. The transistor of claim 4 in which said minority carrier trap surrounds the collector on at least three sides.

9. The transistor of claim 1 in which said minority carrier trap comprises a plurality of n-doped regions and a plurality of p-doped regions arranged in a checkerboard pattern.

10. The transistor of claim 1 in which said minority carrier trap comprises interdigitated fingers.

11. The transistor of claim 3 in which said transistor is a MOS transistor and said minority carrier trap is in a doped well.

12. The transistor of claim 1 in which said minority carrier trap includes one or more p doped and respective adjacent n doped regions.

13. The transistor of claim 12 in which at least one p doped region is electrically connected to an n doped region.

14. The transistor of claim 1 in which said minority carrier trap includes one or more p doped regions and respective closely spaced n doped regions.

15. A method comprising forming a minority catcher in a substrate, said substrate comprising either the base of a bipolar transistor or a well of a MOS transistor.

16. The method of claim 15 including the steps of: forming a patterned a resist over said substrate; exposing said substrate to a dopant species; activating said dopant species.
